**Europäisches Patentamt**

**European Patent Office**

**Office européen des brevets**

(19)

(11) Veröffentlichungsnummer: **0 087 175**
**B1**

(12) **EUROPÄISCHE PATENTSCHRIFT**

(45) Veröffentlichungstag der Patentschrift:
**14.05.86**

(51) Int. Cl.⁴: **H 03 G 1/00**

(21) Anmeldenummer: **83200115.0**

(22) Anmeldetag: **26.01.83**

(54) Schaltung zur elektronischen Verstärkungsstellung.

(30) Priorität: **08.02.82 DE 3204217**

(43) Veröffentlichungstag der Anmeldung:
**31.08.83 Patentblatt 83/35**

(45) Bekanntmachung des Hinweises auf die Patenterteilung:
**14.05.86 Patentblatt 86/20**

(84) Benannte Vertragsstaaten:
**DE FR GB IT**

(56) Entgegenhaltungen:
**DE - A - 2 910 093**
**DE - A - 3 021 788**
**DE - A - 3 024 142**
**DE - B - 2 262 089**
**DE - C - 2 404 331**
**US - A - 3 714 462**

**RADIO FERNSEHEN ELEKTRONIK, Band 28, Nr. 12, Dezember 1979, Berlin, P. EDELMANN "Integrierte Lautstärke- und Klangeinsteller A273 und A274", Seiten 751-757**

(73) Patentinhaber: **Philips Patentverwaltung GmbH, Billstrasse 80, D-2000 Hamburg 28 (DE)**

(84) Benannte Vertragsstaaten: **DE**

(73) Patentinhaber: **N.V. Philips' Gloeilampenfabrieken, Groenewoudseweg 1, NL-5621 BA Eindhoven (NL)**

(84) Benannte Vertragsstaaten: **FR GB IT**

(72) Erfinder: **Zogg, Urs, Althardstrasse 30, CH-8105 Regensdorf (CH)**

(74) Vertreter: **Hartmann, Heinrich, Dipl.-Ing. et al, Philips Patentverwaltung GmbH Billstrasse 80 Postfach 10 51 49, D-2000 Hamburg 28 (DE)**

## Beschreibung

Die Erfindung bezieht sich auf eine Schaltung zur elektronischen Verstärkungsstellung, d.h. auf eine Schaltung, deren Verstärkung durch eine Steuerspannung veränderbar ist. Eine solche Schaltung ist aus der DE-C-24 04 331 bekannt. Darin sind zwei Wandlerschaltungen enthalten, deren hochohmige Ausgänge mit den Eingängen je einer Stromverteilungsschaltung verbunden ist. Zwei Ausgänge der Stromverteilungsschaltungen, deren Ausgangsströme durch die Steuerspannung am Steuereingang der Stromverteilungsschaltung steuerbar sind, haben einen gemeinsamen Widerstand, der von den Ausgangsströmen durchflossen wird. Die Spannung an diesem Widerstand wird über einen Verstärker im Sinne einer Gegenkopplung auf die Eingänge der beiden Wandlerschaltungen rückgeführt, wobei der einen Wandlerschaltung auch noch das Eingangssignal der Schaltung zugeführt wird.

In vielen Fällen sind bei einer solchen Schaltung exakt dB-lineare Steuerkennlinien erwünscht, d.h. die Amplitude der Ausgangsspannung soll entsprechend einer e-Funktion mit der Steuerspannung verknüpft sein. Die bekannte Schaltung weist jedoch nur in einem sehr begrenzten Verstärkungsbereich eine dB-lineare Steuerkennlinie auf und liefert an ihrem Ausgang ausserdem verhältnismässig starke geradzahlige Harmonische. – Der letztgenannte Nachteil wird bei der Schaltung nach der DE-A-30 24 142 vermieden. Dabei werden zusätzlich zwei weitere Stromverteilungsschaltungen und zwei weitere Wandlerschaltungen benutzt, wobei das Signal den zusätzlichen Stromverteilungsschaltungen über die zusätzlichen Wandlerschaltungen mit entgegengesetzter Phasenlage zugeführt wird wie den beiden anderen Stromverteilungsschaltungen. Die Ausgangsspannung wird subtrahiert. Auch diese Schaltung hat jedoch nur in einem relativ kleinen Bereich eine dB-lineare Steuerkennlinie.

Es ist weiterhin aus der US-PS 3 714 462 eine Schaltung zur elektronischen Verstärkungsstellung bekannt, die zwei pnp- und zwei npn-Transistoren enthält und in einem relativ grossen Bereich eine dB-lineare Steuerkennlinie hat, wenn die Kennlinien dieser Transistoren einander entsprechen. Weil hierbei aber Transistoren entgegengesetzten Leitfähigkeitstyps mit angepassten Kennlinien erforderlich sind, ist diese Schaltung praktisch nicht in integrierter Schaltungstechnik auszuführen.

Aufgabe der vorliegenden Erfindung ist es, eine Schaltung zu schaffen, die in einem relativ grossen Bereich eine dB-lineare Steuerkennlinie hat und deren Eigenschaften nur von Transistoren eines Leitfähigkeitstyps bestimmt sind.

Eine erste Lösung dieser Aufgabe ist im Anspruch 1 angegeben.

Eine zweite Lösung dieser Aufgabe, die ausgeht von einer Schaltung zur elektronischen Verstärkungsstellung mit zwei Stromverteilungsschaltungen mit je zwei Ausgängen, wobei das Ausgangsstromverhältnis exponentiell in Abhängigkeit von der Steuerspannung an ihren Steuereingängen steuerbar ist, besteht darin, dass eine Stromregelschaltung vorgesehen ist, die den Eingängen der Stromverteilungsschaltung gegenphasige gleich grosse Signalströme zuführt und deren Amplitude in Abhängigkeit vom Eingangssignal der Schaltung so regelt, dass die Ausgangsströme an je einem der beiden Ausgänge der beiden Stromverteilungsschaltungen dem Eingangssignal proportional und unabhängig von der Steuerspannung sind und dass das Ausgangssignal der Schaltung aus wenigstens einem der durch die Steuerspannung gleichsinnig gesteuerten Ausgangsströme an den beiden anderen Ausgängen der Stromverteilungsschaltungen abgeleitet ist.

Bei beiden Lösungen wird eine Stromverteilungsschaltung benutzt, bei der das Verhältnis der Ausgangsströme exponentiell von der Steuerspannung am Steuereingang der Stromverteilungsschaltung abhängt. Stromverteilungsschaltungen dieser Art sind bekannt. Sie bestehen im einfachsten Fall aus zwei bipolaren emittergekoppelten Transistoren. Die miteinander verbundenen Emitter stellen den Signaleingang der Stromverteilungsschaltung dar und die beiden Kollektoren die beiden Ausgänge der Stromverteilungsschaltung. Die Steuerspannung wird den Basiselektroden der beiden Transistoren zugeführt. Die dB-lineare Kennlinie wird im wesentlichen nur durch die Kennlinie dieser die Stromverteilungsschaltungen bildenden Transistoren bestimmt, die den gleichen Leitfähigkeitstyp haben.

Während jedoch bei der ersten Lösung der Eingangssignalstrom der Stromverteilungsschaltung konstant und unabhängig von der Steuerschaltung bleibt, bleibt bei der zweiten Lösung nur der Strom in jeweils einem Zweig der Stromverteilungsschaltungen von der Steuerspannung unabhängig, weshalb der Strom im anderen Zweig der Stromverteilungsschaltung exponentiell wächst und daraus das Ausgangssignal der Schaltung abgeleitet werden kann.

Ein Vorteil der zweiten Schaltung gegenüber der ersten ist, dass die Schaltung bei symmetrischer Auslegung praktisch keine geradzahligen Oberwellen mehr aufweist. Dieser Vorteil kann aber auch bei der ersten Lösung erreicht werden, wenn nach einer Weiterbildung der Erfindung die Schaltung so ausgestaltet ist, dass eine dritte und eine vierte, der ersten und der zweiten gleichartige Stromverteilungsschaltung vorgesehen ist, an deren Steuereingängen ebenfalls die Steuerspannung anliegt, dass die erste und die zweite Wandlerschaltung jeweils gegenphasige Ausgänge besitzen, dass die beiden Ausgänge der ersten Wandlerschaltung mit den Signaleingängen der ersten und dritten Stromverteilungsschaltung und die Ausgänge der zweiten Wandlerschaltung mit den Signaleingängen der zweiten und vierten Stromverteilungsschaltung verbunden sind, dass die durch die Steuerspannung gleichsinnig in der Amplitude gesteuerten Ausgangsströme der ersten bzw. der dritten Stromverteilungsschaltung jeweils den durch die Steuerspannung gegensinnig beeinflussten Ausgangsströmen der zweiten bzw. der vierten Stromverteilungsschaltung überlagert sind, und der Verstärker die Differenz der überlagerten Ausgangsströme bildet.

Die Erfindung wird nachstehend anhand der Zeichnung näher erläutert. Es zeigen

Fig. 1 ein Ausführungsbeispiel, das die erste Lösung verkörpert und

Fig. 2 ein Ausführungsbeispiel, das die zweite Lösung verkörpert.

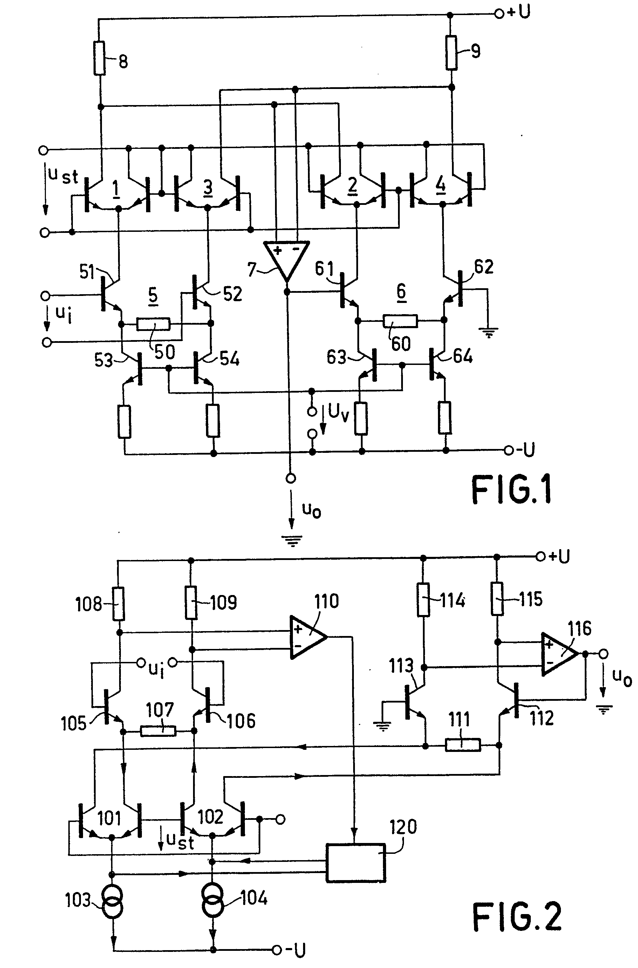

Die Schaltung in Fig. 1 enthält vier Stromverteilungsschaltungen 1 . . .4, von denen jede aus zwei bipolaren Transistoren gleichen Leitfähigkeitstyps, vorzugsweise vom npn-Typ, besteht, deren Emitter miteinander verbunden sind. Bekanntlich wird der Strom, der den Emittern eines derartigen Transistorpaares zugeführt wird, durch eine Steuerspannung zwischen den Basen dieser Transistoren so aufgeteilt, dass der Quotient der Kollektorströme exponentiell von der Steuerspannung abhängt.

Die vier Transistoren der ersten und der zweiten bzw. der dritten und der vierten Stromverteilungsschaltung sind über Kreuz miteinander gekoppelt, d.h. so, dass jeder der vier Transistoren mit jedem der drei anderen Transistoren eine einzige gleichartige Elektrode gemeinsam hat (z.B. haben die beiden linken Transistoren der Stromverteilungsschaltung 1 und 2 den Kollektor miteinander gemeinsam, usw.). Zwischen den Basiselektroden der Transistoren jeder einzelnen Stromverteilungsschaltung wirkt die Steuergleichspannung $u_{st}$.

Die Eingänge der ersten und der dritten Stromverteilungsschaltung 1 bzw. 3, d.h. die jeweils miteinander verbundenen Emitter der beiden Transistoren dieser Stromverteilungsschaltungen, sind mit den gegenphasigen Ausgängen einer ersten Wandlerschaltung 5 verbunden. Aufgabe der Wandlerschaltung 5 ist es, ein ihrem Eingang zugeführtes Eingangssignal $u_i$ in zwei an ihren Ausgängen abnehmbare Signalströme mit gleicher Amplitude und entgegengesetzter Phasenlage umzusetzen.

Zu diesem Zweck enthält die Wandlerschaltung 5 zwei npn-Transistoren 51, 52, deren Kollektoren die gegenphasigen Ausgänge der Wandlerschaltung bilden, zwischen deren Basisanschlüssen das Eingangssignal $u_i$ eingespeist wird und in deren Emitterzuleitungen Gleichstromquellen 53 bzw. 54 vorgesehen sind, die durch die Kollektor-Emitter-Strecken jeweils eines npn-Transistors mit Emitterwiderstand gebildet werden, deren Basis an eine geeignete Vorspannung $U_v$ angeschlossen ist. Die von den Transistoren 51 und 52 abgewandten Anschlüsse der Stromquellen 53 und 54 sind mit einer negativen Versorgungsspannungsklemme $-U$ verbunden. Zwischen die Emitter der beiden Transistoren 51 und 52 ist ein Zweipol 50 geschaltet, der aus einem Widerstand, einem Kondensator oder einer Induktivität, jedoch auch aus einer Kombination dieser Elemente, gegebenenfalls auch in Verbindung mit einer aktiven Schaltung, bestehen kann. Der Signalstrom durch diesen Zweipol ist der Eingangsspannung $u_i$ zwischen den Basiselektroden der Transistoren 51 und 52, von denen eine mit einem geeigneten Bezugspotential, z.B. Masse, verbunden sein kann, proportional und hat den Wert $u_i/Z_1$, wobei $Z_1$ die Impedanz des Zweipols 50 ist.

Mit den Eingängen der zweiten und der vierten Stromverteilungsschaltung 2 bzw. 4 sind die hochohmigen und gegenphasigen Ausgänge einer zweiten Wandlerschaltung 6 verbunden, die den gleichen Aufbau hat wie die Wandlerschaltung 5. Sie enthält dementsprechend zwei Transistoren 61 und 62, deren Kollektoren mit den miteinander verbundenen Emittern der Stromverteilungsschaltungen 2 bzw. 4 verbunden sind, deren Emitter über Stromquellen 63 bzw. 64 mit der negativen Versorgungsspannung $-U$ und über einen Zweipol 60 miteinander verbunden sind, wobei die Basis des Transistors 62 mit Masse und die Basis des Transistors 61 mit dem Ausgang eines Operationsverstärkers 7 verbunden ist. Der Strom durch den Zweipol hat dabei den Wert $u_0/Z_2$, wobei $u_0$ die Ausgangsspannung des Operationsverstärkers 7 ist und $Z_2$ die Impedanz des Zweipols 60.

Die Wandlerschaltung 5 liefert an ihren Ausgängen gegenphasige Ströme der Grösse $u_i/Z_1$, die durch die Stromverteilungsschaltungen 1 und 3 entsprechend der Steuerspannung $u_{st}$ aufgeteilt werden. Die Kollektoren des linken Transistors der Stromverteilungsschaltung 1 und des rechten Transistors der Stromverteilungsschaltung 3, deren Basen miteinander verbunden sind, mit anderen Worten, die Ausgänge, an denen die Ausgangsströme durch die Steuergleichspannung $u_{st}$ in der Amplitude gleichsinnig beeinflusst werden, sind mit gleich grossen Widerständen 8 bzw. 9 verbunden, deren anderes Ende an eine positive Speisespannungsklemme $+U$ angeschlossen ist. Mit dem Widerstand 8 ist ausserdem ein Ausgang der Stromverteilungsschaltung 2 und mit dem Widerstand 9 ein Ausgang der Stromverteilungsschaltung 4 verbunden, und zwar diejenigen Ausgänge, an denen sich die Amplituden der Ausgangsströme in Abhängigkeit von der Steuerspannung $u_{st}$ gegensinnig zu den Amplituden der Ausgangsströme an den mit den Widerständen 8 und 9 verbundenen Ausgängen der Stromverteilungsschaltungen 1 und 3 ändern. Die Stromverteilungsschaltungen 1 und 3 führen also den Widerständen 8 und 9 jeweils gleich grosse Wechselströme mit entgegengesetzter Phasenlage zu. Das gleiche gilt für die Stromverteilungsschaltungen 2 und 4. Die Spannung am Widerstand 8 wird also durch die Überlagerung der Ausgangsströme der Stromverteilungsschaltungen 1 und 2 bestimmt, während die Spannung am Widerstand 9 durch die Überlagerung der Ausgangsströme der Stromverteilungsschaltungen 3 und 4 bestimmt ist.

Die Spannungen an den Widerständen 8 und 9 werden den beiden Eingängen eines Differenzverstärkers 7 zugeführt, und zwar mit solcher Phasenlage, dass die Elemente 7, 61, 2 und 8 bzw. 7, 62, 4, und 9 jeweils einen Gegenkopplungskreis bilden.

Es lässt sich zeigen, dass bei einer solchen Schaltung die Signalspannung an jedem der Widerstände 8 bzw. 9 praktisch Null ist und dass die Verstärkung $v = u_O/u_i$ der Gleichung genügt

$$V = \frac{Z_2}{Z_1} \cdot e^{-c} \qquad (1),$$

falls die Ungleichung

$$V \gg \frac{1 + e^c}{e^c} \cdot \frac{R_8 + R_9}{Z_2} \qquad (2)$$

erfüllt ist. Dabei ist e die Basis der natürlichen Logarithmen, c ein Wert, der dem Quotienten aus der Steuerspannung $u_{st}$ und der Temperaturspannung ($u_T \approx 26$ mV bei 300 K) bzw. dem Logarithmus des Quotienten der Ausgangsströme einer Stromverteilungsschaltung entspricht, und der bei der aus der Zeichnung ersichtlichen Polarität von $u_{st}$ positiv ist, und $R_8$ und $R_9$ die Widerstandswerte der Widerstände 8 und 9.

Stromverteilungsschaltungen, wie sie in Fig. 1 dargestellt sind, rufen in der Regel geradzahlige Harmonische hervor. Diese Harmonischen haben jedoch in den die Widerstände 8 bzw. 9 durchfliessenden Ausgangsströme der Stromverteilungsschaltungen 1 und 3 einerseits und der Stromverteilungsschaltungen 2 und 4 andererseits jeweils die gleiche Phasenlage, so dass sie sich am Ausgang des Differenzverstärkers 7 kompensieren.

Die Widerstände 8 und 9 müssen einander nicht gleich sein, wenn eine dB-lineare Steuerkennlinie erhalten werden soll. Jedoch werden die geradzahligen Oberwellen um so weniger kompensiert, je mehr die Widerstände 8 und 9 voneinander abweichen. Im Extremfall kann die eine Hälfte der Schaltung – z.B. der Widerstand 9, die Stromverteilungsschaltungen 3 und 4 und die Elemente 52 und 54 bzw. 62 und 64 der Wandlerschaltungen 5 und 6 – entfallen, wenn der mit dem Widerstand 9 verbundene Eingang des Operationsverstärkers 7 auf ein geeignetes Gleichspannungspotential gelegt wird; allerdings kompensieren sich die geradzahligen Harmonischen dann nicht mehr und treten in voller Grösse in der Ausgangsspannung $u_O$ auf.

Es sei noch bemerkt, dass das Potential am Eingang des Wandlers 5 positiver sein muss als das Potential –U an der negativen Speisespannungsklemme und z.B. Null Volt betragen kann. Das Potential an den Steuereingängen, an denen die Steuerspannung $u_{st}$ anliegt, muss dann um einige Basis-Emitter-Vorspannungen positiver sein als das Potential an den Eingangsklemmen des Wandlers 5, damit ein einwandfreier Betrieb möglich ist.

Das in Fig. 2 dargestellte Ausführungsbeispiel der zweiten Lösung verwendet ebenfalls Stromverteilungsschaltungen 101 und 102, die den gleichen Aufbau haben wie die Stromverteilungsschaltungen 1 bis 4 der Fig. 1. Die Basis jeweils eines Transistors einer Stromverteilung ist mit der Basis eines Transistors der anderen Stromverteilung verbunden. Zwischen den Basisanschlüssen der jeweils eine Stromverteilungsschaltung bildenden npn-Transistoren ist eine Steuerspannung $u_{st}$ wirksam. Die Eingänge der Stromverteilungsschaltungen 101 bzw. 102, d.h. die Emitter der die Stromverteilungsschaltung bildenden npn-Transistoren, sind über je eine Gleichstromquelle 103 bzw. 104 mit einer Versorgungsspannungsklemme verbunden, die ein negatives Potential –U führt. Die Kollektoren zweier Transistoren der Stromverteilungsschaltungen 101 und 102, deren Basen miteinander verbunden sind, d.h. diejenigen Ausgänge der Stromverteilungsschaltungen, deren Ausgangsströme in ihrer Amplitude durch die Steuerspannung $u_{st}$ gleichsinnig verändert werden, sind mit den Emitteranschlüssen zweier Transistoren 105 und 106 verbunden, zwischen denen ein Zweipol 107 eingeschaltet ist. Zwischen den Basiselektroden der Transistoren 105 und 106 wird das Eingangssignal $u_i$ eingespeist und ihre Kollektoranschlüsse sind über Widerstände 108 und 109 mit einer positives Potential +U führenden Speisespannungsklemme verbunden. Anstelle einzelner Transistoren 105 und 106 kann jedoch auch eine andere Schaltungskonfiguration gewählt werden, die jeweils einen niederohmigen Folgerausgang und einen weiteren, hochohmigen Ausgang aufweist, z.B. eine Darlington-Schaltung, wobei die Ausgänge der Stromverteilungsschaltungen 101, 102 zwar auch mit den Emittern der Ausgangstransistoren der Darlington-Schaltung jedoch auch mit den Emittern der davorliegenden Transistoren verbunden sein können.

Die Spannung an den beiden vorzugsweise gleich grossen Widerständen 108 und 109 wird von einem Operationsverstärker 110 verstärkt und dem Eingang einer Wandlerschaltung 120 zugeführt, die daraus zwei zur Ausgangsspannung des Verstärkers 110 proportionale, in ihrer Amplitude gleiche, in ihrer Phase jedoch entgegengesetzte Signalströme erzeugt, die den Eingängen der Stromverteilungsschaltung 101 bzw. 102 mit solcher Phasenlage zugeführt werden, dass sich eine Gegenkopplung ergibt.

Es lässt sich zeigen, dass auch bei dieser Schaltung die Signalspannung an jedem der beiden Eingänge des Operationsverstärkers 110 praktisch Null wird bzw. die Kollektor-Signalströme vernachlässigbar klein gegenüber dem Strom durch den Zweipol 107 sind, wenn das Produkt aus dem Widerstandswert eines der Widerstände 108 und 109, der Verstärkung des Operationsverstärkers 110 und der Steilheit der Wandlerschaltung 120 gross im Vergleich zu dem Ausdruck $1 + e^c$ ist. Das bedeutet jedoch, dass die Ströme an den mit den Transistoren 105 und 106 verbundenen Ausgängen der Stromverteilungsschaltung 102 dem Betrage nach gleich sind und dem Strom durch den Zweipol 107 entsprechen, der durch

die Beziehung $u_i/Z_1$ gegeben ist, wobei $Z_1$ die Impedanz des Zweipols 107 darstellt – und zwar unabhängig von der Steuerspannung $u_{st}$.

Die beiden Stromverteilungsschaltungen 101 und 102 sind hierbei also in einen Regelkreis bzw. in einen Gegenkopplungskreis aufgenommen, der erzwingt, dass die Signalströme an den mit den Transistoren 105 bzw. 106 verbundenen Ausgängen der Eingangsspannung $u_i$ proportional werden, und zwar unabhängig von der Steuerspannung $u_{st}$. Dies wird dadurch erreicht, dass aufgrund der hohen Verstärkung in der Gegenkopplungs- bzw. Rückkopplungsschleife erreicht wird, dass die Ströme durch die Widerstände 108 und 109 vernachlässigbar klein gegenüber dem Strom durch den Widerstand 107 sind. Im Falle einer etwaigen Abweichung ändern sich die vom Stromwandler 120 gelieferten Wechselströme in der Weise, dass wiederum der Signalstrom durch bzw. der Signalspannungsabfall an den Widerständen 108 und 109 vernachlässigbar klein ist.

Da nun weiter das Verhältnis der Ströme an den beiden Ausgängen einer solchen Stromverteilungsschaltung bekanntlich exponentiell von der Steuerspannung abhängt, ist der Strom an den Ausgängen der Stromverteilungsschaltungen 101 und 102, die nicht mit den Transistoren 105 und 106 verbunden sind, um den Faktor $e^{-c}$, wobei c je nach Polarität der Steuerspannung $u_{st}$ positive und negative Werte haben kann, kleiner bzw. grösser als der Strom durch den Widerstand 107. Der Signalspannungsabfall, der an einem mit einem dieser Ausgänge verbundenen Widerstand hervorgerufen würde, dividiert durch die Eingangssignalspannung $u_i$ würde daher bereits exponentiell von der Steuerspannung $u_{st}$ abhängen, jedoch wäre diese Ausgangsspannung einerseits relativ hochohmig und andererseits nicht frei von zweiten Harmonischen. Wenn hingegen die Ausgangsströme bzw. dazu proportionale Signale voneinander subtrahiert werden, ergibt sich eine Kompensation der geradzahligen Harmonischen, weil diese in den Ausgangsströmen gleichphasig auftreten, während die eigentlichen Signalkomponenten in den Ausgangsströmen gegenphasig sind.

Zu diesem Zweck sind die nicht mit den Transistoren 105 und 106 verbundenen Ausgänge der Stromverteilungsschaltungen 101 und 102 über eine zweite Impedanz 111 miteinander verbunden. Betrachtet man die Spannung an dieser Impedanz als Ausgangsspannung, dann genügt die Verstärkung der Gleichung (1), wenn mit $Z_2$ die Impedanz des zweiten Zweipols 111 bezeichnet wird. Da sich hierbei jedoch immer noch ein relativ grosser Ausgangswiderstand ergibt, ist der Zweipol 111 zwischen die Emitteranschlüsse zweier npn-Transistoren 112 und 113 geschaltet, deren Kollektoren über gleich grosse Widerstände 114 und 115 mit der positiven Speisespannungsklemme +U verbunden sind. Die Basiselektrode des einen der beiden Transistoren (113) ist mit Bezugspotential, z.B. Masse, verbunden und die Basiselektrode des anderen Transistors (112) mit dem Ausgang eines Operationsverstärkers 116, der die Differenz der an den Widerständen 114 und 115 verstärkt, und zwar derart, dass sich eine Gegenkopplung ergibt. Die Ausgangsspannung $u_0$ dieses Operationsverstärkers entspricht der Spannung am Zweipol 111, wird jedoch von einer niederohmigen Spannungsklemme geliefert und ist unsymmetrisch gegen Masse.

Bei der durch die Strompfeile gekennzeichneten Halbwelle des Eingangssignals sind der Transistor 105 und die Transistoren der Stromverteilungsschaltung 101 stärker leitend als der Transistor 106 bzw. die Transistoren der Stromverteilungsschaltung 102. Bei der entgegengesetzten Halbwelle ist es gerade umgekehrt. Es ergibt sich dadurch ein Gegentaktbetrieb, bei dem bekanntlich keine geradzahligen Harmonischen auftreten.

Wie schon ausgeführt, haben die beiden Schaltungen nach Fig. 1 und Fig. 2 nicht nur das eingangs erwähnte Grundprinzip gemeinsam, sondern auch die Tatsache, dass die Verstärkung in exakt gleicher Weise von der Steuerspannung $u_{st}$ sowie von den Impedanzen $Z_1$ und $Z_2$ abhängt (vgl. Gleichung (1)). Für beide Schaltungen ergeben sich daher entsprechende Anwendungsmöglichkeiten. Wenn die erste und die zweite Impedanz 50 und 60 bzw. 107 und 111 reell sind oder aber ihr Phasenwinkel sich in gleicher Weise als Funktion der Frequenz ändert, können die Schaltungen zur elektronischen Verstärkungsstellung, bei der die Verstärkung gleichmässig über ein breiteres Frequenzband verstellt wird, benutzt werden, gegebenenfalls auch als Lautstärkesteller in einem Audioverstärker. Die Höhe der Verstärkung kann dabei durch geeignete Wahl von $Z_1$ und $Z_2$ vorgegeben werden. Eine solche Schaltung ist auch zur automatischen Verstärkungsregelung bei Hochfrequenzempfängern verwendbar.

Wenn hingegen eine der beiden Impedanzen oder beide Impedanzen in unterschiedlicher Weise von der Frequenz abhängig sind, ist eine von der Steuerspannung $u_{st}$ abhängige Frequenzgangsbeeinflussung bzw. eine frequenzabhängige Verstärkungsstellung möglich, woraus sich eine Verwendungsmöglichkeit als Filter mit spannungsgesteuerter Eckfrequenz bzw. als Klangsteller in Audioverstärkern ergibt.

Wenn der erste Zweipol 50 bzw. 107 ein ohmscher Widerstand ist und der zweite Zweipol 60 bzw. 111 ein Kondensator bzw. eine kapazitive Impedanz, ergibt sich ein Integrator mit elektronisch steuerbarer Zeitkonstante, der beispielsweise in der Regelungstechnik einsetzbar ist.

Die Phase des Ausgangssignals kann in beiden Fällen durch Vertauschen der Eingangsanschlüsse um 180° gedreht werden.

**Patentansprüche**

1. Schaltung zur elektronischen Verstärkungsstellung mit einer ersten Wandleranordnung (5) mit hochohmigem Ausgang, der mit dem Signaleingang einer ersten Stromverteilungsschaltung (1) verbunden ist, deren Ausgangsstromverhältnis exponentiell mit einer Steuerspannung ($u_{st}$)

an ihrem Steuereingang änderbar ist, und mit einer zweiten Stromverteilungsschaltung (2), deren Steuereingang dem Steuereingang der ersten Stromverteilungsschaltung (1) parallelgeschaltet ist und deren Signaleingang mit dem hochohmigen Ausgang einer zweiten Wandlerschaltung (6) verbunden ist, wobei ein Verstärker (7) vorgesehen ist, dessen Eingangsspannung aus der Überlagerung zweier durch die Steuerspannung ($u_{st}$) entgegengesetzt geänderter Ausgangsströme der beiden Stromverteilungsschaltungen (1, 2) gebildet wird und dessen Ausgangsspannung die Ausgangsspannung ($u_O$) der Schaltung bildet und zum Zwecke einer Gegenkopplung benutzt wird, dadurch gekennzeichnet, dass die Ausgangsspannung des Verstärkers (7) im Sinne einer Gegenkopplung lediglich dem Eingang der zweiten Wandlerschaltung (6) zugeführt ist, so dass das Signal am Eingang der ersten Wandlerschaltung (5) unabhängig vom Ausgangssignal des Verstärkers (7) ist und nur vom Eingangssignal ($u_i$) der Schaltung bestimmt wird.

2. Schaltung nach Anspruch 1, dadurch gekennzeichnet, dass eine dritte und eine vierte der ersten und der zweiten gleichartige Stromverteilungsschaltung (3, 4) vorgesehen ist, an deren Steuereingängen ebenfalls die Steuerspannung ($u_{st}$) anliegt, dass die erste und die zweite Wandlerschaltung (5, 6) gegenphasige Ausgänge besitzen, dass die Ausgänge der ersten Wandlerschaltung (5) mit den Signaleingängen der ersten und der dritten Stromverteilungsschaltung (1, 3) und die Ausgänge der zweiten Wandlerschaltung (6) mit den Signaleingängen der zweiten und vierten Stromverteilungsschaltung (2, 4) verbunden sind, dass die durch die Steuerspannung gleichsinnig in der Amplitude gesteuerten Ausgangsströme der ersten bzw. der dritten Stromverteilungsschaltung (1, 3) jeweils den durch die Steuerspannung gegensinnig beeinflussten Ausgangsströmen der zweiten bzw. der vierten Stromverteilungsschaltung (2, 4) überlagert sind, und dass der Verstärker (7) die Differenz der überlagerten Ausgangsströme bildet.

3. Schaltung nach Anspruch 2, dadurch gekennzeichnet, dass der erste und/oder der zweite Wandler (5; 6) zwei Transistoren (51, 52; 61, 62) enthalten, zwischen deren Emittern ein erster bzw. ein zweiter Zweipol (50; 60) wirksam ist und in deren Emitterzuleitung jeweils eine Konstantstromquelle (53, 54; 63, 64) aufgenommen ist, dass das Eingangssignal der Wandlerschaltung den Basiselektroden der Transistoren zugeführt ist und das Ausgangssignal aus den Kollektorströmen der Transistoren abgeleitet ist.

4. Schaltung zur elektronischen Verstärkungsstellung mit zwei Stromverteilungsschaltungen mit je zwei Ausgängen, wobei das Ausgangsstromverhältnis exponentiell in Abhängigkeit von der Steuerspannung ($u_{st}$) an ihren Steuereingängen steuerbar ist, dadurch gekennzeichnet, dass eine Stromregelschaltung (105...110, 120) vorgesehen ist, die den Eingängen der Stromverteilungsschaltung gegenphasige gleich grosse Signalströme zuführt und deren Amplitude in Abhängigkeit vom Eingangssignal ($u_i$) der Schaltung so regelt, dass die Ausgangsströme an je einem der beidenAusgänge der beiden Stromverteilungsschaltungen dem Eingangssignal ($u_i$) proportional und unabhängig von der Steuerspannung ($u_{st}$) sind und dass das Ausgangssignal ($u_o$) der Schaltung aus wenigstens einem der durch die Steuerspannung gleichsinnig gesteuerten Ausgangsströme an den beiden anderen Ausgängen der Stromverteilungsschaltungen abgeleitet ist.

5. Schaltung nach Anspruch 4, dadurch gekennzeichnet, dass die Stromregelschaltung einen Eingangswandler (105...109), einen an dessen Ausgang angeschlossenen Verstärker (110) und einen Stromwandler (120) umfasst, der das Ausgangssignal des Verstärkers in zwei gegenphasige gleich grosse Ströme umsetzt, die den Eingängen der Stromverteilungsschaltungen (101, 102) zugeführt sind und dass der Eingangswandler zwei symmetrisch angeordnete Transistoren (105, 106) umfasst, zwischen deren Emittern ein erster, mit den Ausgängen der Stromverteilungsschaltungen (101, 102) gekoppelter Zweipol (107) geschaltet ist, an deren Basen das Eingangssignal ($u_i$) der Schaltung anliegt und aus deren Kollektorstrom das Eingangssignal des Verstärkers (110) gebildet ist.

6. Schaltung nach Anspruch 5, dadurch gekennzeichnet, dass das Ausgangssignal ($u_o$) aus der Differenz der Ströme an den nicht mit dem Eingangswandler (105...109) verbundenen Ausgängen der Stromverteilungsschaltungen (101, 102) gebildet ist.

7. Schaltung nach Anspruch 6, dadurch gekennzeichnet, dass die Ausgangsspannung an einem zweiten Zweipol (111) anliegt, der zwischen die nicht mit dem Eingangswandler (105...109) verbundenen beiden Ausgänge der Stromverteilungsschaltungen (101, 102) geschaltet ist.

8. Schaltung nach einem der Ansprüche 3 oder 7, dadurch gekennzeichnet, dass der erste und/oder zweite Zweipol (50 bzw. 60; 107 bzw. 111) eine frequenzabhängige Impedanz aufweist.

9. Schaltung nach einem der Ansprüche 3 oder 7, dadurch gekennzeichnet, dass der zweite Zweipol (60; 111) eine kapazitive Impedanz aufweist.

**Revendications**

1. Circuit pour la commande électronique de l'amplification comportant un premier circuit de conversion (5) muni d'une sortie à valeur ohmique élevée, qui est connectée à l'entrée de signal d'un premier circuit de répartition de courant (1), dont le rapport de courant de sortie est en fonction exponentielle de la tension de commande ($u_{st}$) à son entrée de commande, et un deuxième circuit de répartition de courant (2), dont l'entrée de commande est montée en parallèle à l'entrée de commande du premier circuit de répartition de courant (1) et dont l'entrée de signal est connectée à la sortie à valeur ohmique élevée d'un deuxième circuit de conversion (6), un amplificateur (7) étant prévu et sa tension d'entrée est formée par la superposition de deux courants de sortie des deux circuits de répartition de courant (1, 2), courants de sortie qui sont modifiés en sens opposés par la tension de commande ($u_{st}$) et dont la tension de sortie constitue la tension de sortie ($u_o$) du circuit, qui est utilisée pour une contre-réaction, caractérisé en ce que la tension de sortie de l'amplificateur (7) n'est amenée, dans le sens d'une contre-réaction, qu'à l'entrée du deuxième circuit de conversion (6), de sorte que le signal se produisant à l'entrée du premier circuit de conversion (5) ne dépend pas du signal de sortie de l'amplificateur (7) et n'est déterminé que par le signal d'entrée ($u_i$) du circuit.

2. Circuit selon la revendication 1, caractérisé par la présence de troisième et quatrième circuits de répartition de courant analogues aux premier et deuxième circuits de répartition de courant (3, 4), aux entrées de commande desquels est également appliquée la tension de commande ($u_{st}$), les premier et deuxième circuits de conversion (5, 6) présentant chacun des sorties qui sont en opposition de phase, les sorties du premier circuit de conversion (5) sont connectées aux entrées de signal des premier et troisième circuits de répartition de courant (1, 3) et les sorties du deuxième circuit de conversion (6) sont connectées aux entrées de signal des deuxième et quatrième circuits de répartition de courant (2, 4), les courants de sortie des premier et troisième circuits de répartition de courant, dont les amplitudes de courant-sortie sont commandées dans le même sens par la tension de commande, sont superposés aux courants de sortie des deuxième et quatrième circuits de répartition de courant (1, 3) respectivement, dont les courants de sortie sont influencés de façon opposée par la tension de commande, l'amplificateur (7) formant la différence des courants de sortie superposés.

3. Circuit selon la revendication 2, caractérisé en ce que le premier et/ou le deuxième convertisseur (5; 6) contient deux transistors (51, 52; 61, 62) entre les émetteurs desquels est actif un premier dipôle respectivement un deuxième dipôle (50; 60) et dans la ligne d'émetteur est insérée chaque fois une source de courant continu (53, 54; 63, 64), que le signal d'entrée du circuit de conversion est amené aux électrodes de base des transistors et que le signal de sortie est dérivé des courants de collecteur des transistors.

4. Circuit pour le réglage électronique de l'amplification comportant deux circuits de répartition de courant munis de chaque fois deux sorties, dans lequel le rapport du courant de sortie est en fonction exponentielle de la tension de commande ($u_{st}$) à ses entrées de commande, caractérisé par la présence d'un circuit de réglage de courant (105 . . .110, 120), qui applique des courants de signal qui sont égaux mais en opposition de phase aux entrées des circuits de répartition de courant et qui assurent le réglage de leur amplitude en fonction du signal d'entrée ($u_i$) de façon que les courants de sortie à chacune des deux sorties des deux circuits de répartition de courant soient proportionnels au signal d'entrée ($u_i$) et indépendants de la tension de commande ($u_{st}$) et

que le signal de sortie ($u_o$) du circuit est dérivé d'au moins l'un des courants de sortie des autres sorties du circuit de répartition de courant, courants de sortie qui sont commandés dans le même sens par la tension de commande.

5. Circuit selon la revendication 4, caractérisé en ce que le circuit de réglage de courant comprend un convertisseur d'entrée (105 . . .109), un amplificateur (110) connecté à sa sortie et un convertisseur de courant (120) qui assure la conversion du signal de sortie de l'amplificateur en deux courants égaux en opposition de phase qui sont amenés aux entrées des circuits de répartition de courant (101, 102) et que le convertisseur d'entrée comprend deux transistors symétriques (105, 106) entre les émetteurs desquels est monté un premier dipôle (107) couplé aux sorties des circuits de répartition de courant (101, 102) aux bases desquels est appliqué le signal d'entrée ($u_i$) du circuit et à partir du courant de collecteur duquel est formé le signal d'entrée de l'amplificateur (110).

6. Circuit selon la revendication 5, caractérisé en ce que le signal de sortie ($u_o$) est formé par la différence des courants aux sorties des circuits de répartition de courant (101, 102) qui ne sont pas connectées au convertisseur d'entrée (105 . . .109).

7. Circuit selon la revendication 1, caractérisé en ce que la tension de sortie est appliquée à un deuxième dipôle (111) qui est monté entre les deux sorties des circuits de répartition de courant (101, 102) qui ne sont pas connectées au convertisseur d'entrée (105 . . .109).

8. Circuit selon l'une des revendications 3 ou 7, caractérisé en ce que le premier et/ou deuxième dipôle (50 respectivement 60; 107 respectivement 111) présente une impédance dépendant de la fréquence.

9. Circuit selon l'une des revendications 3 ou 7, caractérisé en ce que le deuxième dipôle (60; 111) présente une impédance capacitive.

**Claims**

1. An electronic gain-control arrangement comprising a first converter circuit (6) having a high-impedance output which is connected to the signal input of a first current distribution circuit (1), whose output current ratio is variable as an exponential function of a control voltage ($u_{st}$) on its control input, and comprising a second current distribution circuit (2) whose control input is arranged in parallel with the control input of the first current distribution circuit (1) and whose signal input is connected to the high-impedance output of a second converter circuit (6), an amplifier (7) being provided whose input voltage is formed out of the superposition of two output currents of the two current distribution circuits (1, 2), which output currents are varied oppositely by the control voltage ($u_{st}$), and whose output voltage constitutes the output voltage ($u_o$) of the arrangement and is used for the purpose of negative feedback, characterized in that the output voltage of the amplifier (7) is applied by way of negative feedback only to the input of the second converter circuit (6) so that the signal on the input of the first converter circuit (5) is independent of the output signal of the amplifier (7) and is determined only by the input signal ($u_i$) of the arrangement.

2. An arrangement as claimed in Claim 1, characterized in that there is provided a third and a fourth current distribution circuit (3, 4) similar to the first and the second current distribution circuit, the control inputs of said third and fourth current distribution circuits also receiving the control voltage ($u_{st}$), the first and the second converter circuit (5, 6) each have outputs which are in phase opposition, the outputs of the first converter circuit (5) are connected to the signal inputs of the first and the third current distribution circuit (1, 3) and the outputs of the second converter circuit (6) are connected to the signal inputs of the second and the fourth current distribution circuit (2, 4), the output currents of the first and the third current distribution circuit (1, 3) respectively, whose output-current amplitudes are controlled in the same sense by the control voltage, are superimposed on the output currents of the second and the fourth current distribution circuit (2, 4) respectively, whose output currents are influenced oppositely by the control voltage, and the amplifier (7) forms the difference of the superimposed output currents.

3. An arrangement as claimed in Claim 2, characterized in that the first and/or the second converter (5; 6) each comprises two transistors (51, 52; 61, 62), between whose emitters a first and a second two-terminal network (50; 60) respectively is arranged and in whose emitter line a constant-current (53, 54; 63, 64) is arranged, the input signal of the converter circuit is applied to the base electrodes of the transistors and the output signal is derived from the collector currents of the transistors.

4. An electronic gain-control arrangement comprising two current distribution circuits each having two outputs, the output current ratio being controllable as an exponential function of the control voltage ($u_{st}$) on their control inputs, characterized in that there is provided a current control circuit (105 ... 110, 120), which supplies signal currents which are equal but in phase opposition to the inputs of the current distribution circuit and which controls their amplitudes depending on the input signal ($u_i$) of the arrangement in such a way that the output currents on each one of the two outputs of the two current distribution circuits are proportional to the input signal ($u_i$) and independent of the control voltage ($u_{st}$), and the output signal ($u_o$) of the arrangement is derived from at least one of the output currents on the two other outputs of the current distribution circuits, which output current are controlled in the same sense by the control voltage.

5. An arrangement as claimed in Claim 4, characterized in that, the current control circuit comprises an input converter (105 ...109), an amplifier (110) connected to the output of said converter, and a current converter (120), which converts the output signal of the amplifier into two equal currents which are in phase opposition and which are applied to the inputs of the current distribution circuits (101, 102), and the input converter comprises two symmetrically arranged transistors (105, 106) between whose emitters a first two-terminal network (107), which is coupled to the outputs of the current distribution circuits (101, 102), is arranged, to whose bases the input signal ($u_i$) of the arrangement is applied, and from whose collector currents the input signal of the amplifier (110) is derived.

6. An arrangement as claimed in Claim 5, characterized in that, the output signal ($u_o$) is formed by the difference of the currents on those outputs of the current distribution circuits (101, 102) which are not connected to the input converter (105 ...109).

7. An arrangement as claimed in Claim 6, characterized in that, the output voltage is applied to a second two-terminal network (111) which is arranged between those two outputs of the current distribution circuits (101, 102) which are not connected to the input converter (105 ...109).

8. An arrangement as claimed in any one of the Claims 3 or 7, characterized in that the first and/or the second two-terminal network (50 and 60 respectively; 107 and 111 respectively) comprise(s) a frequency-dependent impedance.

9. An arrangement as claimed in any one of the Claims 3 or 7, characterized in that the second two-terminal network (60; 111) comprises a capacitive impedance.

FIG.1

FIG.2